# EUROPÄISCHE PATENTSCHRIFT

(11) **EP 1 949 780 B1**
(45) Veröffentlichungstag und Bekanntmachung des Hinweises auf die Patenterteilung: **19.08.2009**
(21) Anmeldenummer: 07820727.1
(22) Anmeldetag: 28.09.2007
(51) Int. Cl.: H05K 13/04

(54) **BESTÜCKKOPF MIT RÜCKSTELLEINRICHTUNG UND BESTÜCKAUTOMAT**
PLACEMENT HEAD COMPRISING A READJUSTING MECHANISM, AND PLACEMENT ROBOT
TÊTE D'ÉQUIPEMENT COMPORTANT UN DISPOSITIF DE RAPPEL ET AUTOMATE D'ÉQUIPEMENT

(30) Priorität: 07.11.2006 DE 102006052454
(43) Veröffentlichungstag der Anmeldung: 30.07.2008
(73) Patentinhaber: Siemens Electronics Assembly Systems GmbH & Co. KG, 81379 München (DE)
(72) Erfinder: BURGER, Stefan, 81379 München (DE)
(86) Internationale Anmeldenummer: PCT/EP2007/060340
(87) Internationale Veröffentlichungsnummer: WO 2008/055748

(56) Entgegenhaltungen:
- WO-A-02/104091
- WO-A-20/05034602

## Beschreibung

Die Erfindung betrifft einen Bestückkopf zum Bestücken von Substraten mit elektrischen Bauteilen, sowie einen Bestückautomaten mit einem derartigen Bestückkopf.

In der Technik gibt es zahlreiche Beispiele, in der Bauteile gehandhabt werden müssen, beispielsweise in der Bestücktechnik. In der Bestücktechnik werden Substrate mit elektrischen Bauteilen bestückt. Der Bestückvorgang wird durch einen Bestückkopf durchgeführt, welcher mittels eines zweidimensionalen Positioniersystems über dem zu bestückenden Substrat verfahrbar ist. Der Bestückkopf weist dabei eine oder mehrere Halteeinrichtungen auf, welche in einer Richtung senkrecht zur Substratoberfläche zwischen einer Ruheposition und einer Arbeitsposition bewegbar sind. Zur Durchführung eines Arbeitsvorgangs, d.h. zum Aufnehmen bzw. Absetzen der Bauteile, wird die Haltevorrichtung mittels eines geeigneten elektrischen Antriebs in die Arbeitsposition bewegt. In der Zeit, in der die Halteinrichtung keinen Arbeitsvorgang durchführen muss, beispielsweise beim Verfahren des Bestückkopfes, wird sie von dem Antrieb in der Ruheposition gesichert, um Beschädigungen zu verhindern. Da die Halteeinrichtung auch im freien Zustand, d.h. bei unbestromtem Antrieb, in der sicheren Ruheposition gehalten werden muss, ist sie mit einer Rückstelleinrichtung, wie beispielsweise einem Pneumatikzylinder oder einer Feder gekoppelt, welche die Halteeinrichtung selbst im freien bzw. unbestromten Zustand des Antriebs in die Ruheposition verschiebt.

Der Pneumatikzylinder bzw. die Feder übt demnach auf die Halteeinrichtungen permanent eine Rückstellkraft aus, welche die Halteeinrichtung in die Ruheposition drängt. Zum Bestücken oder zum Aufnehmen der Bauteile muss der Antrieb die Halteeinrichtung entgegen dieser Rückstellkraft in die Arbeitsposition bewegen. Gerade beim Bestücken und Abholen sehr empfindlicher und kleiner Bauteile ist die Aufsetzkraft, mit der die Halteeinrichtung selbst auf das Bauteil aufsetzt oder das Bauteil auf das Substrat aufsetzt, so gering wie möglich zu halten und so präzise wie möglich einzustellen. Dies bedingt jedoch eine exakte Vorbestimmung der vom Pneumatikzylinder oder von der Feder ausgeübten Rückstellkraft.

Bei Pneumatikzylindern ist jedoch aufgrund der Reibungskraft zwischen dem Druckkolben bzw. der Dichtungen und dem Zylinder eine Hysterese zu beobachten, welche einen negativen Einfluss auf die Positioniergenauigkeit des Reglers hat. Ferner ist die Rückstellkraft verschleißabhängig und damit nicht langzeitstabil. Außerdem wird zum Betrieb des Pneumatikzylinders Hilfsenergie, wie Druckluft, benötigt. Bei Federn tritt das Problem der Alterung auf, so dass sich mit der Zeit nicht nur die Kraftkennlinie der Feder ändert, sondern auch ein Federbruch eintreten kann. Außerdem ändert sich die Rückstellkraft mit dem Federweg, sodass bei unterschiedlich hohen Bauteilen unterschiedliche Rückstellkräfte auftreten. Somit ist sowohl bei der Feder als auch bei dem Pneumatikzylinder die Rückstellkraft und damit die Aufsetzkraft nur unzureichend vorbestimmbar. Dies kann im schlimmsten Fall zu einer Beschädigung der Bauteile oder des Substrats führen, was den Bestückvorgang negativ beeinflusst. Des Weiteren unterliegen Pneumatikzylinder und Federn einer Alterung und müssen regelmäßig gewartet werden.

WO 02/104091 A offenbart einen Bestückkopf mit einem Gehäuse, einer Halteeinrichtung zum Halten von Bauteilen, einer Verschiebeeinrichtung und einer mit dem Gehäuse gekoppelten magnetischen Rückschlusseinrichtung mit Permanentmagnet.

Es ist deshalb die Aufgabe der vorliegenden Erfindung, einen Bestückkopf und einen Bestückautomaten zu liefern, mit denen die Prozesssicherheit erhöht werden kann.

Diese Aufgabe wird durch den Bestückkopf und den Bestückautomaten gemäß den unabhängigen Ansprüchen gelöst. Vorteilhafte Ausgestaltungen sind Gegenstand der abhängigen Ansprüche.

Ein Bestückkopf gemäß Anspruch 1 umfasst ein Gehäuse sowie mindestens eine Halteeinrichtung zum Halten der Bauteile. Die Halteeinrichtung ist in einer Verschieberichtung zwischen den Ruhepositionen und Arbeitspositionen verschiebbar am Gehäuse gelagert, wobei die Ruheposition und die Arbeitsposition in der Verschieberichtung um eine Hubstrecke beabstandet sind. Der Bestückkopf umfasst ferner eine Rückstelleinrichtung, mit einem quer zur Verschieberichtung magnetisierten Permanentmagneten sowie einer magnetischen Rückschlusseinrichtung, welche derart mit dem Permanentmagneten zusammenwirkt, dass sich ein magnetischer Rückschluss bildet. Der Permanentmagnet ist relativ zur Rückschlusseinrichtung in der Verschieberichtung um die Hubstrecke verschiebbar. Die Rückschlusseinrichtung weist in Verschieberichtung zumindest zwei Abschnitte mit unterschiedlichem magnetischem Widerstand bzw. magnetischem Fluss auf und ist derart ausgebildet, dass der Permanentmagnet beim Verschieben über die Hubstrecke gleichzeitig mit zumindest zwei Abschnitten der Rückschlusseinrichtung überlappt. Die Rückstelleinrichtung ist derart mit dem Gehäuse und der Halteeinrichtung gekoppelt, dass die Rückstelleinrichtung auf die Halteeinrichtung über die Hubstrecke eine Kraft ausübt, welche die Halteeinrichtung in die Ruheposition drängt.

Bei der Rückstelleinrichtung kommt der physikalische Effekt zu tragen, dass der Permanentmagnet im freien Zustand, d.h. ohne Einwirkung anderer äußerer Kräfte, immer bestrebt ist sich in Richtung des Abschnittes der Rückstelleinrichtung mit dem geringeren magnetischen Widerstand bzw. mit dem größeren magnetischen Fluss zu bewegen. Der Permanentmagnet wird durch die besondere Ausgestaltung der Rückschlusseinrichtung aufgrund magnetischer Effekte in den Abschnitt mit dem geringeren magnetischen Widerstand gedrängt. Durch entsprechende Ausgestaltung der Abschnitte kann die Kraft, mit der der Permanentmagnet in den Abschnitt mit dem geringeren magnetischen Widerstand drängt, exakt eingestellt werden. Damit ist die Rückstellkraft, mit der die Rückstelleinrichtung die Halteeinrichtung in die Ruheposition drängt, exakt definierbar, weitgehend hysteresefrei und langzeitstabil. Außerdem können durch entsprechende Ausgestaltung der Abschnitte beliebige Kraftkennlinien dargestellt werden. Die Rückstelleinrichtung ist ferner berührungslos, verschleißfrei und bedarf keiner Wartung. Des Weiteren ist im Unterschied zu Pneumatikzylindern keine Hilfsenergie erforderlich. Somit wird die Halteeinrichtung im freien Zustand des Bestückkopfes zuverlässig in die Ruheposition bewegt.

In einer Ausgestaltung des Bestückkopfes gemäß Anspruch 2 sind die Rückschlusseinrichtung mit dem Gehäuse und der Permanentmagnet mit der Halteeinrichtung fest verbunden. In diesem Fall bildet die Rückschlusseinrichtung den stationären Teil der Rückstelleinrichtung, wogegen der Permanentmagnet zusammen mit der Halteeinrichtung in der Verschieberichtung bewegt wird.

Im Gegensatz dazu sind gemäß der Ausgestaltung nach Anspruch 3 der Permanentmagnet mit dem Gehäuse und die Rückschlusseinrichtung mit der Halteeinrichtung fest verbunden. In diesem Fall ist der Permanentmagnet das stationäre Teil der Rückstelleinrichtung, welche am Gehäuse befestigt ist, wogegen sich die Rückschlusseinrichtung zusammen mit der Halteeinrichtung in der Verschieberichtung bewegt.

Gemäß den Ausgestaltungen der Ansprüche 4 und 5 kann der unterschiedliche magnetische Widerstand bzw. der unterschiedliche magnetische Fluss der Abschnitte der Rückschlusseinrichtung auf zwei unterschiedliche Arten erreicht werden. So können die Abschnitte aus Materialien mit unterschiedlichem magnetischem Widerstand gefertigt sein. Beispielsweise könnte ein Abschnitt aus Weicheisen (geringer magnetischer Widerstand, hoher magnetische Fluss) und der andere Abschnitt aus einer Edelstahlsorte (hoher magnetischer Widerstand und geringer magnetischen Fluss) bestehen. Die Abschnitte können jedoch auch aus Ferrit oder allgemein aus Stahlwerkstoffen bestehen. Alternativ zur Wahl der Werkstoffe können die Abschnitte auch derart ausgestaltet sein, dass sie von dem Permanentmagneten unterschiedlich weit beabstandet sind. Durch den unterschiedlichen Abstand ergibt sich zwischen dem Permanentmagneten und den Abschnitten ein unterschiedlich breiter Luftspalt, wobei der magnetische Widerstand mit zunehmender Luftspaltbreite zunimmt. Auch eine Kombination der beiden Methoden ist denkbar.

Gemäß einer weiteren Ausgestaltung nach Anspruch 6 sind die Abschnitte der Rückschlusseinrichtung derart ausgebildet, dass die Rückstellkraft über die gesamte Hubstrecke konstant ist. Damit ist die Rückstellkraft eindeutig vorhersagbar, was die Regelungsgenauigkeit und das dynamische Verhalten sowohl bei einer Kraft- als auch bei einer Positionsregelung deutlich erhöht.

In der Ausgestaltung nach Anspruch 7 befindet sich ein von der Halteeinrichtung gehaltenes Bauteil in der Ruheposition näher am Gehäuse als in der Arbeitsposition. Dadurch wird gewährleistet, dass die Halteeinrichtung in der Ruheposition nicht zu weit vom Gehäuse wegragt, wodurch Beschädigungen verhindert werden.

In einer Ausgestaltung des Bestückkopfes nach Anspruch 8 umfasst dieser einen elektromagnetischen Antrieb zum Bewegen der Halteeinrichtung in der Verschiebeeinrichtung. Der elektromagnetische Antrieb weist ein am Gehäuse befestigtes Stationärteil mit zumindest einem Spulenpaket auf. Der Permanentmagnet der Rückstelleinrichtung ist dabei Teil eines Mobilteiles des Hubantriebes, welches bei Betrieb mit den Spulenelementen zusammenwirkt. Bei dieser Ausgestaltung wird der Permanentmagnet der Rückstelleinrichtung gleichzeitig als Mobilteil für einen elektrischen Hubantrieb verwendet. Bei entsprechender Bestromung des Spulenpakets wird der Permanentmagnet zusammen mit der Halteinrichtung in Verschiebrichtung bewegt. Dadurch werden Bauteile eingespart, was Gewichts- und Kostenvorteile mit sich.bringt. Ferner kann der Bestückkopf kompakter gebaut werden.

Gemäß einer Ausgestaltung des Bestückkopfes nach Anspruch 9 ist das Mobilteil bzw. der Permanentmagnet als Rotor ausgebildet und relativ zum Stationärteil um eine zur Verschieberichtung parallele Drehachse drehbar gelagert. Das Spulenpaket des Stationärteiles ist mehrphasig ausgestaltet. Die Handhabungseinrichtung weist eine Steuereinrichtung auf, welche mit dem Spulenpaket gekoppelt ist und mittels der der Strom durch das Spulenpaket derart steuerbar ist, dass das dadurch verursachte Magnetfeld des Stationärteiles mit dem Magnetfeld des Mobilteiles bzw. des Permanentmagneten wechselwirkt und sowohl eine Verschiebung in Verschieberichtung als auch eine Rotation des Rotors um die Drehachse bewirkt. In dieser Ausgestaltung ist der Antrieb als integrierter Dreh-Hub-Motor ausgestaltet, wodurch sich eine weitere Vereinfachung des konstruktiven Aufbaues ergibt und der Bestückkopf noch kompakter gebaut werden kann.

Bei einem Bestückkopf nach Anspruch 10 weist das Stationärteil ein Spulenpaket (19) in Form eines zylinderförmigen Hohlkörpers auf, mit einer Wicklung, welche derart gestaltet ist, dass die Steigung über die einzelnen Windungsgänge entlang des Umfangs des zylinderförmigen Hohlkörpers verläuft. Dabei kann es sich beispielsweise um eine Schrägwicklung, deren Windungen schräg zu den Mantellinien des zylinderförmigen Hohlkörpers verlaufen, oder auch um eine Rhombuswicklung mit rautenförmigen Windungen handeln. Als Mantellinien werden dabei die Linien bezeichnet, die auf dem Mantel eines Rotationskörpers, z. B. eines Zylinders, längs zu seiner Rotationsachse verlaufen. Beide Windungsgeometrien zeichnen sich durch eine sehr kompakte Bauweise aus und ermöglichen durch den schrägen Verlauf der Windungen relativ zur Drehachse eine hohe Axialkraft.

Ein Bestückautomat gemäß Anspruch 11 weist einen Bestückkopf gemäß einem der vorausgehenden Ansprüche auf. Bezüglich der Vorteile wird auf die Ausführungen bezüglich der Ansprüche 1 bis 10 verwiesen.

Im Folgenden werden Ausführungsbeispiele des Bestückautomaten und des Bestückkopfes mit Bezug auf die beigefügten Figuren näher erläutert. In den Figuren sind:
- Figur 1: eine schematische Ansicht eines Bestückautoma- ten,
- Figuren 2A und 2B: schematische Darstellungen eines Bestückkop- fes,
- Figuren 3A und 3B: schematische Darstellungen einer ersten Aus- gestaltung der Rückstelleinrichtung,
- Figuren 4A und 4B: schematische Darstellungen einer zweiten Aus- gestaltung der Rückstelleinrichtung,
- Figuren 5A und 5B: schematische Darstellungen einer dritten Aus- gestaltung der Rückstelleinrichtung,
- Figuren 6A und 6B: schematische Querschnittsansichten der Rück- stelleinrichtung,
- Figur 7: eine schematische Darstellung einer vierten Ausgestaltung der Rückstelleinrichtung.
- Figuren 8A und 8B: ein schematisches Wirkprinzip des Dreh-Hub- Motors

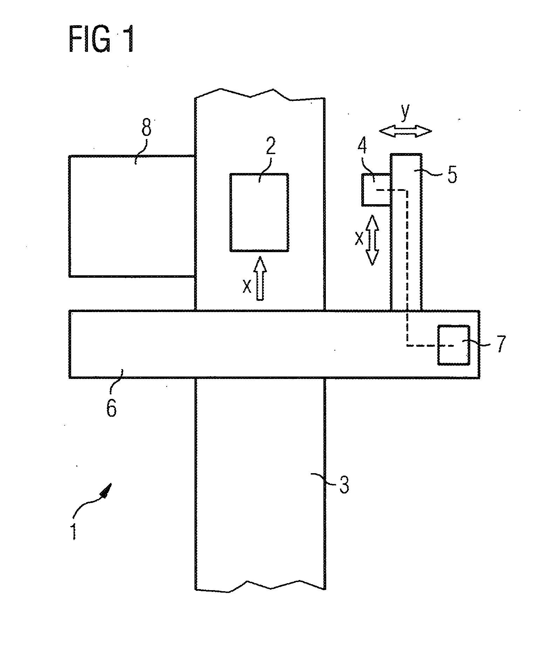

In Figur 1 ist ein Bestückautomat 1 zum Bestücken von Substraten mit elektrischen Bauteilen schematisch dargestellt.

Zu bestückende Substrate 2 werden über eine Transportstrecke 3, beispielsweise ein Transportband, zu einem Bestückplatz transportiert, dort mit elektrischen Bauteilen bestückt und anschließend abtransportiert. Der Bestückvorgang wird durch einen Bestückkopf 4 durchgeführt. Der Bestückkopf 4 ist in einer zur Transportrichtung (Pfeil x) der Substrate 2 parallelen Richtung (Pfeil x) verschiebbar an einem Positionierarm 5 angebracht. Der Positionierarm 5 wiederum ist quer (Pfeil y) zur Transportrichtung an einem Träger 6 angebracht, welcher die Transportstrecke 3 brückenartig überspannt. Der Bestückautomat 1 umfasst ferner eine Steuereinrichtung 7, welche mit dem Positionierarm 5 und dem Bestückkopf 4 gekoppelt ist und die Bewegungsabläufe steuert. Seitlich der Transportstrecke 3 ist in einem Zuführbereich eine Zuführeinrichtung 8 vorgesehen, welche die elektrischen Bauteile für den Bestückkopf 4 bereitstellen. Vor dem Bestücken wird der Bestückkopf 4 mittels des Positionierarmes 5 zu der Zuführeinrichtung 8 gefahren, wo er Bauteile 11 aufnimmt, und wird anschließend über das Substrat 2 verfahren, wo er die Bauteile 11 auf dem Substrat 2 absetzt.

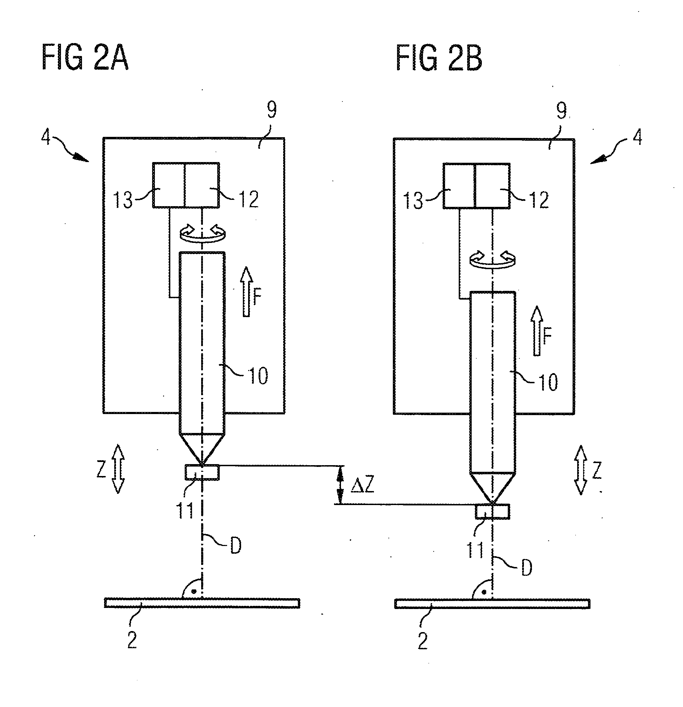

In den Figuren 2A und 2B ist der Bestückkopf 4 schematisch dargestellt. Der Bestückkopf 4 umfasst ein Gehäuse 9 sowie eine Halteeinrichtung 10 zum Halten der Bauteile 11, welche in einer Verschieberichtung (Pfeil z) senkrecht zur Substratoberfläche verschiebbar am Gehäuse 9 gelagert ist. Dabei kann die Halteeinrichtung 10 zwischen einer Ruheposition (in Figur 2A dargestellt) und einer Arbeitsposition (in Figur 2B dargestellt) hin und her bewegt werden. Die Ruheposition und die Arbeitsposition sind in Verschieberichtung um eine Hubstrecke Δz beabstandet.

Der Bestückkopf 4 umfasst ferner eine Rückstelleinrichtung 12, welche derart mit dem Gehäuse 9 und der Halteeinrichtung 10 gekoppelt ist, dass die Rückstelleinrichtung 12 auf die Halteeinrichtung 10 über die Hubstrecke eine Rückstellkraft F ausübt, welche parallel zur Verschieberichtung gerichtet ist und die Halteeinrichtung 10 in die Ruheposition (Figur 2A) drängt. Auf den genauen Aufbau der Rückstelleinrichtung 12 wird später noch eingegangen.

Der Bestückkopf 4 weist ferner einen Antrieb 13 auf, welcher die Halteeinrichtung 10 von der Ruheposition in die Arbeitsposition bewegt. Der Antrieb 13 kann derart ausgestaltet sein, dass er die Halteeinrichtung 10 um eine Drehachse D rotieren lässt. Dies dient dazu, ein an der Halteeinrichtung 10 gehaltenes Bauteil 11 in eine vorgeschriebene Winkelposition zu bringen. Wie aus den Figuren 2A und 2B ferner hervorgeht, ist ein von der Halteeinrichtung 10 gehaltenes Bauteil 11 in der Ruheposition (Figur 2A) näher am Gehäuse 9 angeordnet als in der Arbeitsposition (Figur 2B). Die Ruheposition wird daher insbesondere dann eingenommen, wenn der Bestückkopf 4 verfahren wird bzw. wenn die Halteeinrichtung 10 keinen Arbeitsvorgang wie beispielsweise das Bestücken oder das Abholen von Bauteilen 11 vornimmt. Dies dient zum Schutz der Halteeinrichtung 10 sowie des Bauelements 11.

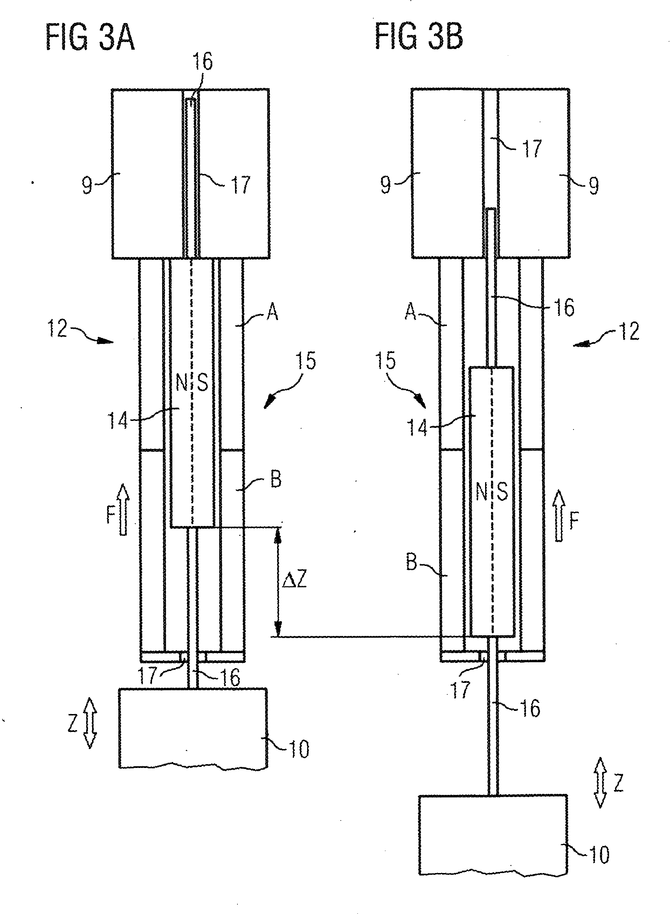

In den Figuren 3A und 3B ist eine erste Ausgestaltung der Rückstelleinrichtung 12 schematisch dargestellt. Die Rückstelleinrichtung 12 ist mit dem Gehäuse 9 und der Halteeinrichtung 10 gekoppelt. Dabei ist die Halteeinrichtung 10 in Figur 3A in der Ruheposition und in Figur 3B in der Arbeitsposition dargestellt. Die Rückstelleinrichtung 12 umfasst einen Permanentmagneten 14, sowie eine magnetische Rückschlusseinrichtung 15, welche mit dem Permanentmagneten 14 derart zusammenwirkt, dass sich ein magnetischer Rückschluss bildet. Der Permanentmagnet 14 ist relativ zur Rückschlusseinrichtung 15 in der Verschieberichtung (Pfeil z) um die gleiche Hubstrecke Δz, wie die Halteeinrichtung 10, verschiebbar. Der Permanentmagnet 14 weist ferner einen magnetischen Nordpol (N) und einen magnetischen Südpol (S) auf, welche quer zur Verschieberichtung (Pfeil z) orientiert sind. Die Rückschlusseinrichtung 15 weist in Verschieberichtung zumindest zwei Abschnitte A, B mit unterschiedlichem magnetischem Widerstand bzw. magnetischem Fluss auf. Die Abschnitte A, B sind derart ausgebildet bzw. angeordnet, dass der Permanentmagnet 14 beim Verschieben über die Hubstrecke Δz gleichzeitig zumindest zwei Abschnitte A, B der Rückschlusseinrichtung 15 überlappt.

Der Permanentmagnet 14 ist bestrebt, sich in Richtung des Abschnittes A, B mit dem geringeren magnetischen Widerstand bzw. dem höheren magnetischen Fluss zu bewegen. Dadurch, dass der Permanentmagnet 14 über die gesamte Hubstrecke Δz beide Abschnitte A, B überlappt, wirkt die Rückstellkraft F über die gesamte Hubstrecke Δz.

In der ersten Ausgestaltung gemäß den Figuren 3A und 3B sind die Rückschlusseinrichtung 15 fest mit dem Gehäuse 9 und der Permanentmagnet 14 fest mit der Halteeinrichtung 10 verbunden. Somit bewegt sich der Permanentmagnet 14 zusammen mit der Halteeinrichtung 10 in Verschieberichtung relativ zum Gehäuse 9 bzw. zur Rückschlusseinrichtung 15. Der Permanentmagnet 14 stellt daher in dieser Ausgestaltung den mobilen Teil der Rückstelleinrichtung 12 dar. Wie bezüglich der Figuren 2A und 2B schon erwähnt wurde, zeichnet sich die Ruheposition gegenüber der Arbeitsposition der Halteeinrichtung 10 dadurch aus, dass die Halteeinrichtung 10 in der Ruheposition weniger weit vom Gehäuse 9 wegragt bzw. sich ein von der Halteeinrichtung 10 gehaltenes Bauteil 11 näher am Gehäuse 9 befindet als in der Arbeitsposition. Aufgrund des oben beschriebenen physikalischen Effekts sind die Abschnitte A, B der Rückschlusseinrichtung 15 deshalb derart ausgebildet und angeordnet, dass der magnetische Widerstand des Abschnitts A kleiner ist als der magnetische Widerstand des Abschnitts B. Auf die mit dem Permanentmagneten 14 gekoppelte Halteeinrichtung 10 wirkt daher die Rückstellkraft F, welche die Halteeinrichtung 10 im freien Zustand in die Ruheposition drängt (in Figur 3A dargestellt). Dieser Zustand wird auch eingenommen, wenn der gesamte Bestückkopf 4 stromfrei geschaltet ist, so dass sich die Halteeinrichtung 10 auch in stromfreien bzw. antriebslosen Zustand des Bestückkopfes 4 in der Ruheposition befindet und dadurch vor Beschädigung geschützt ist. Ist mit der Halteeinrichtung 10 ein Arbeitsvorgang durchzuführen, so muss die Halteeinrichtung 10 mittels des Antriebs 13 (siehe Figuren 2A und 2B) gegen die Rückstellkraft F in die Arbeitsposition bewegt werden (in Figur 3B dargestellt).

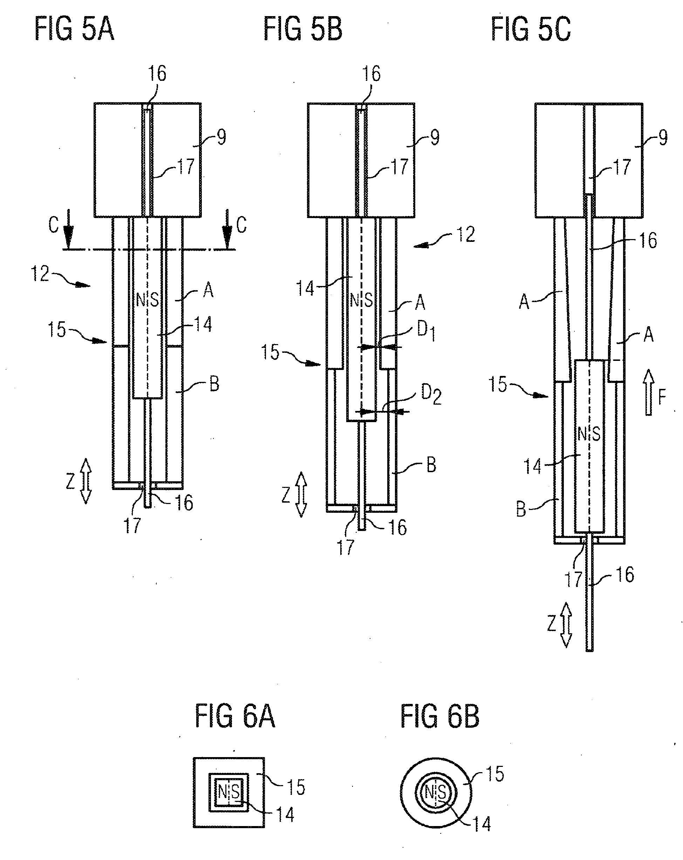

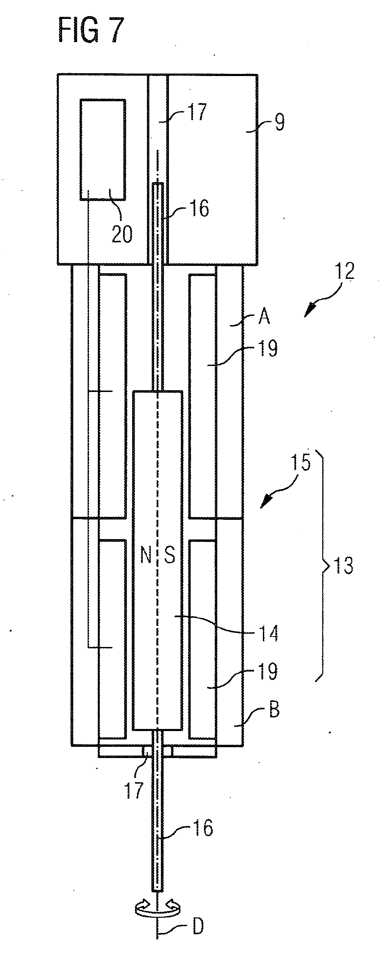

Bei dem in den Figuren 3A und 3B dargestellten Ausführungsbeispiel ist der bewegliche Permanentmagnet 14 an seinen freien Enden mit Führungsstäben 16 ausgestattet, welche in entsprechende am Gehäuse 9 bzw. an einer Verschlussplatte der Rückstelleinrichtung 12 ausgebildete Führungskanäle 17 eintauchen. Neben der Führung des Permanentmagneten 14 in Verschieberichtung dient einer der Führungsstäbe 16 auch als Verbindungsmittel zwischen dem Permanentmagneten 14 und der Halteeinrichtung 10. Der zweite Führungsstab 16 kann zur Ankopplung eines Antriebs 13 an die Rückstelleinrichtung 12 genutzt werden. Der Antrieb 13 kann dabei als reiner Hubantrieb oder auch als Dreh-Hub-Motor ausgestaltet sein. Im Falle eines reinen Hubantriebs sind als Querschnittsformen für die Rückstelleinrichtung 12 sowohl ein rechteckiger oder nichtrotationssymmetrischer Querschnitt als auch ein Kreisquerschnitt möglich (siehe Figuren 6A und 6B). Im Falle eines externen Dreh-Hub-Motors handelt es sich vorzugsweise um einen integrierten Dreh-Hub-Motor wie in Figur 7 dargestellt. Es ist jedoch auch möglich, einen Dreh-Hub-Motor mit zwei separaten Antrieben - einen Ersten für die Hubbewegung und einen Zweiten für die Drehbewegung - zu verwenden.

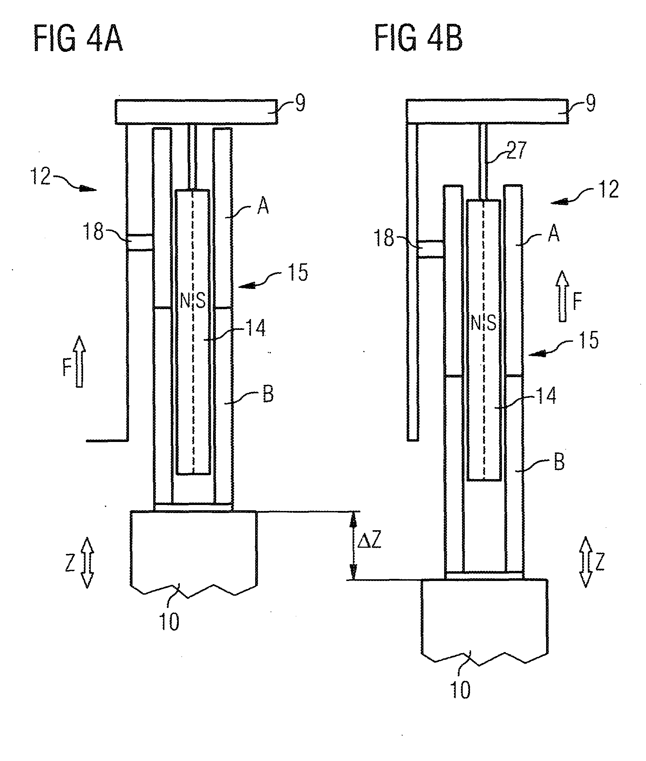

Eine zweite Ausgestaltung der Rückstelleinrichtung 12 ist in den Figuren 4A und 4B dargestellt. Bezüglich des prinzipiellen Aufbaus und des wirkenden physikalischen Effekts entspricht die zweite Ausgestaltung der in Figur 3A und 3B dargestellten ersten Ausgestaltung. Jedoch unterscheidet sich die zweite Ausgestaltung von der ersten Ausgestaltung dadurch, dass hier der Permanentmagnet 14 über ein Befestigungselement 27 fest mit dem Gehäuse 9 und die Rückschlusseinrichtung 15 fest mit der Halteeinrichtung 10 verbunden sind. In diesem Fall bewegt sich daher die Rückschlusseinrichtung 15 zusammen mit der Halteeinrichtung 10 in Verschieberichtung relativ zum Permanentmagneten 14 bzw. zum Gehäuse 9. Mit anderen Worten, stellt in dieser Ausgestaltung der Permanentmagnet 14 den stationären Teil und die Rückschlusseinrichtung 15 den mobilen Teil der Rückstelleinrichtung 12 dar. Die Rückschlusseinrichtung 15 kann zur Stabilisierung der Bewegung mit einer am Gehäuse 9 ausgebildeten Führungseinrichtung 18, wie beispielsweise einer Führungsschiene, verbunden sein.

In Figur 4A befindet sich die Halteinrichtung in der Ruheposition und in Figur 4B in der Arbeitsposition. Im Unterschied zu der in Figur 3A und 3B dargestellten Ausgestaltung ist die Rückstelleinrichtung 12 hier derart ausgebildet, dass der magnetische Widerstand des Abschnitts B der Rückschlusseinrichtung 15 geringer ist als der magnetische Widerstand des Abschnitts A. Dadurch wirkt auf die Halteeinrichtung 10 die Rückstellkraft F, welche die Halteeinrichtung 10 in die in Figur 4A dargestellte Ruheposition drängt. Dies ist damit zu begründen, dass sich die Rückschlusseinrichtung 15 aufgrund des oben erläuterten physikalischen Effekts relativ zum Permanentmagneten 14 im freien Zustand derart bewegt, dass der Permanentmagnet 14 möglichst weit in den Abschnitt B mit dem geringeren magnetischen Widerstand bzw. dem größeren magnetischen Fluss eintaucht. Auch in dieser Ausgestaltung wird daher eine Sicherung der Halteeinrichtung 10 in der Ruheposition im stromlosen Zustand des Bestückkopfes 4 gewährleistet.

Anhand der Figuren 5A, 5B und 5C soll erläutert werden, wie die unterschiedlichen magnetischen Widerstände der Abschnitte A, B der Rückstelleinrichtung 12 realisierbar sind.

Eine erste Möglichkeit ist in Figur 5B dargestellt. Dort sind die Abschnitte A, B vom Permanentmagneten 14 unterschiedlich weit beabstandet. Konkret ist der Abschnitt A weniger weit vom Permanentmagneten 14 beabstandet ist als der Abschnitt B. Dadurch ist der Luftspalt D1 zwischen dem Abschnitt A und dem Permanentmagneten 14 weniger breit als der Luftspalt D2 zwischen dem Abschnitt B und dem Permanentmagneten 14. Unter der Voraussetzung, dass die beiden Abschnitte A, B aus Material mit identischem magnetischen Widerstand bestehen, ist der magnetische Widerstand aufgrund des schmäleren Luftspalts D1 in Abschnitt A kleiner als der magnetische Widersand in Abschnitt B. Dadurch, dass innerhalb der Abschnitte A, B der Abstand zum Permanentmagneten konstant ist, ist die Rückstellkraft F über die gesamte Hubstrecke Δz konstant.

Eine zweite Möglichkeit ist in Figur 5A dargestellt. Dabei ist der Abstand zwischen den Abschnitten A, B und dem Permanentmagneten 14 gleich. Jedoch sind die Abschnitte A, B aus Materialien mit unterschiedlichem magnetischem Widerstand hergestellt. In der Ausgestaltung nach Figur 5A ist beispielsweise Abschnitt A aus Weicheisen, Abschnitt B aus Edelstahl hergestellt. Weicheisen weist gegenüber Edelstahl einen deutlich geringeren magnetischen Widerstand und einen höheren magnetischen Fluss auf. Somit ist der Permanentmagnet 14 immer bestrebt, sich in Richtung des Abschnitt A zu bewegen. Auch hier ist die Rückstellkraft F über die gesamte Hubstrecke annähernd konstant.

Prinzipiell ist es aber auch möglich, beide Möglichkeiten zu verbinden, d.h. Abschnitte A, B aus Materialen mit unterschiedlichem magnetischem Widerstand zu verwenden und diese in unterschiedlichem Abstand zum Permanentmagneten 14 anzuordnen.

Eine dritte Möglichkeit zeigt Figur 5C. Dabei können die beiden Abschnitte A, B aus dem gleichen Material bestehen, jedoch weist Abschnitt B einen konstanten Abstand zum Permanentmagneten 14 auf, wohingegen im Abschnitt A der Abstand zum Permanentmagneten 14 von oben her zur Mitte der Rückschlusseinrichtung 15 hin linear abnimmt. Dies führt dazu, dass auf den Permanentmagneten in der unteren Stellung (gezeichnet) eine hohe Rückstellkraft F wirkt, die bei Verschiebung des Permanentmagneten 14 zum oberen Ende der Hubstrecke □z hin abnimmt. Dies ist dadurch zu erklären, dass im Abschnitt A mit zunehmendem Abstand der magnetische Fluss abnimmt und dementsprechend der magnetische Widerstand zunimmt.

In den Figuren 6A und 6B sind zwei mögliche Querschnittsformen der Rückstelleinrichtung 12 entlang der Schnittlinie C-C in Figur 5A dargestellt. In der Ausgestaltung nach Figur 6A weist die Rückschlusseinrichtung 15 eine Form eins Hohlquaders auf, welcher den quaderförmig ausgebildeten Permanentmagneten 14 einschließt. Bei dieser Ausgestaltung ist lediglich eine Verschiebung des Permanentmagneten 14 relativ zur Rückschlusseinrichtung 15 in Verschieberichtung möglich.

Bei dem in Figur 6B dargestellten Ausführungsbeispiel ist die Rückschlusseinrichtung 15 als Hohlzylinder und der Permanentmagnet 14 als lang gestrecktem Zylinder ausgebildet. Die Rückschlusseinrichtung 15 umgibt den Permanentmagneten 14 dabei radial. Bei dieser Ausgestaltung ist sowohl eine lineare Verschiebung des Permanentmagneten 14 als auch eine Rotation des Permanentmagneten 14 relativ zur Rückschlusseinrichtung 15 möglich. Dadurch kann beispielsweise auf die Halteeinrichtung 10 sowohl ein drehmoment als auch eine lineare Verschiebekraft ausgeübt werden. Durch die Rotation wäre es beispielsweise möglich, ein von der Halteeinrichtung 10 gehaltenes Bauteil 11 in eine bestimmte Winkelposition zu drehen.

In Figur 7 ist eine weitere Ausgestaltung des Bestückkopfes 4 schematisch dargestellt. Danach ist der Antrieb 13 für die Halteeinrichtung 10 als elektromagnetischer Antrieb 13 ausgestaltet. Der Antrieb 13 umfasst ein mit dem Gehäuse 9 fest verbundenes Stationärteil, welches zwei in Verschieberichtung hintereinander angeordnete Spulenpakete 19 mit entsprechenden Spulenwicklungen aufweist. Im Ausführungsbeispiel wird das Stationärteil durch die Rückschlusseinrichtung 15 gebildet, an deren dem Permanentmagneten 14 zugewandten Innenseite die Spulenpakete 19 angeordnet sind. Dem Bestückkopf 4 ist ferner eine Antriebssteuerung 20 zum Steuern des Antriebs zugeordnet, welche mit den Spulenpaketen elektrisch gekoppelt ist. Die Antriebssteuerung 20 kann dabei sowohl am Bestückkopf 4 selbst als auch am Trägerarm 5 oder am Grundkörper des Bestückautomaten 1 angebracht sein. Dadurch kann die verfahrbare Masse reduziert werden, was sich insbesondere bei hohen Beschleunigungen vorteilhaft auswirkt. Die Spulenpakete 19 werden von einer externen Stromquelle (nicht dargestellt) über die Antriebssteuerung 20 mit Strom versorgt.

Diese Ausgestaltung des Bestückkopfes zeichnet sich insbesondere dadurch aus, dass der Permanentmagnet 14 der Rückstelleinrichtung 12 auch gleichzeitig das Mobilteil des Antriebs 13 darstellt. Der Permanentmagnet 14 wirkt dabei mit den bestromten Spulenpaketen 19 derart zusammen, dass sich bei entsprechender Ansteuerung durch die Antriebssteuerung 20 die Halteeinrichtung 10 in der Verschieberichtung bewegt. Bei dieser Ausgestaltung sind also Elemente der Rückstelleinrichtung 12 und des Antriebs 13 zusammengefasst. Dadurch, dass der Permanentmagnet 14 sowohl Bestandteil der Rückstelleinrichtung 12 als auch des Antriebs 13 ist, können Bauelemente eingespart und der Bestückkopf 1 kostengünstiger und kompakter konstruiert werden. Gleichzeitig stellt die Rückschlusseinrichtung 15 auch Teil des Stationärteiles des Antriebs 13 dar.

Obwohl in den Ausgestaltungen gemäß der Figuren 5A, 5B und 7 die Halteeinrichtung 10 mit dem Permanentmagneten 14 gekoppelt ist und dadurch der Permanentmagnet 14 sich zusammen mit der Halteeinrichtung 10 relativ zur Rückschlusseinrichtung 15 bzw. zum Gehäuse 9 bewegt, ist es jedoch auch möglich, dass die Halteeinrichtung 10 mit der Rückschlusseinrichtung 15 gekoppelt ist und sich zusammen mit dieser in Verschieberichtung relativ zum am Gehäuse 9 befestigten Permanentmagneten 14 bewegt, wie es im Ausführungsbeispiel gemäß der Figuren 4A und 4B dargestellt ist.

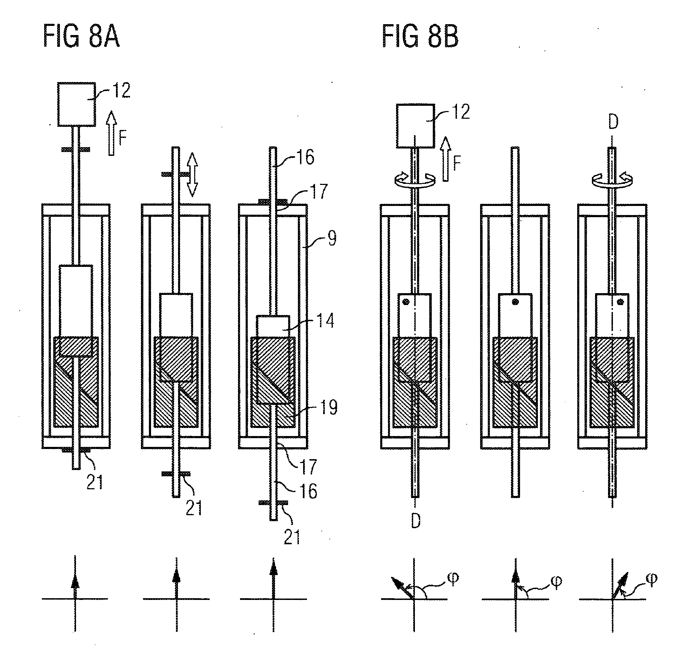

Der Antrieb 13 kann jedoch nicht nur als reiner Linearantrieb zum Bewegen der Halteeinrichtung 10 zwischen der Ruheposition und der Arbeitsposition ausgebildet sein, sondern auch als kombinierter Dreh-Hub-Motor zum gleichzeitigen Verschieben und Drehen der Halteeinrichtung 10. In diesem Fall ist der Permanentmagnet 14 bzw. das Mobilteil als Rotor ausgebildet und relativ zum Stationärteil um die zur Verschieberichtung parallele Drehachse D drehbar gelagert. Dabei bietet sich die Ausgestaltung gemäß der Figur 6B an, bei der der Permanentmagnet 14 zylinderförmig und die Rückschlusseinrichtung 15 als Hohlzylinder ausgebildet ist. Die Spulenpakete 19 des Stationärteiles sind jeweils mehrphasig und die Antriebssteuerung 20 steuert den Strom durch die Spulenpakete 19 derart, dass das durch den Strom verursachte Magnetfeld des Stationärteiles mit dem Magnetfeld des Permanentmagneten 14 wechselwirkt und sowohl eine lineare Verschiebung als auch eine Rotation des Rotors bewirkt. Eine detaillierte Beschreibung dieses Wirkprinzips findet sich in den Erläuterungen zu den Figuren 8A und 8B. Durch die Vorsehung dieses integrierten Dreh-Hub-Motors ergibt sich eine noch kompaktere Bauweise, da auf einen separaten Drehantrieb verzichtet werden kann. In Figur 7 ist der Antrieb 13 als ein in die Rückstelleinrichtung 12 integrierter Antrieb dargestellt. Es ist jedoch auch möglich, Rückstelleinrichtung 12 und Antrieb 13 getrennt voneinander aufzubauen, wie bereits in Figur 3 dargestellt.

In den Figuren 8A und 8B ist das Wirkprinzip des Dreh-Hub-Motors schematisch dargestellt. Da zur Beschreibung dieses Wirkprinzips die magnetische Rückstellung nicht erforderlich ist, wird in den Figuren 8A und 8B auf eine detaillierte Darstellung verzichtet. Die Rückstelleinrichtung 12 ist lediglich abstrahiert als Blackbox angedeutet. Neben der oben detailliert ausgeführten magnetischen Rückstellung kann es sich dabei jedoch auch um eine Feder oder eine pneumatische Rückstellung handeln. In beiden Figuren ist im oberen Teil die Stellung des Permanentmagneten 14 zum zylindrischen Spulenpaket 19 des Dreh-Hub-Motors dargestellt. Figur 8A zeigt dabei die Lage des Permanentmagneten 14 in Richtung der Drehachse D. Die in Figur 8B dargestellte Drehlage des Permanentmagneten 14 wird dabei durch die punktförmige Markierung am oberen Ende des Permanentmagneten 14 verdeutlicht. Im unteren Teil der Darstellungen ist der jeweils dazugehörige Stromvektor des Spulenstroms als Zeigerdiagramm angegeben. Die Diagramme sollen verdeutlichen, wie sich allein durch die Änderung der Amplitude sowie des Phasenwinkels ϕ des Stroms durch das Spulenpaket 19 sowohl eine rotatorische Bewegung als auch eine translatorische Bewegung des als Rotor ausgebildeten Permanentmagneten 14 innerhalb des Gehäuses realisieren lässt. Dabei ist jedoch notwendig, dass die Windungen des Spulenpakets 19 sowohl Richtungsanteile in Orientierungsrichtung der Drehachse D als auch senkrecht dazu in Richtung des Umfangs des zylindrischen Spulenpakets 19 aufweisen. Als mögliche Ausgestaltungsformen der Windungsgeometrie wären die dargestellte Schrägwicklung oder auch eine Rhombuswicklung zu nennen (in den Figuren 8A bzw. 8B nicht dargestellt). Figur 8A zeigt, wie sich der Permanentmagnet 14 bei Variation der Amplitude des Spulenstroms verhält. Der Spulenstrom wird auf einen bestimmten Amplitudenwert eingestellt, so dass die daraus resultierende Axialkraft in z-Richtung betragsmäßig der entgegengesetzt wirkenden Rückstellkraft F entspricht. Wird die Amplitude nun erhöht, so übersteigt die daraus resultierende Axialkraft die entgegengesetzt wirkende Rückstellkraft, der Permanentmagnet 14 des Rotors wird in das Spulenpaket 19 hineingezogen. Hierfür sind diejenigen Richtungsanteile des Spulenstroms verantwortlich, die in Umfangsrichtung, senkrecht zur Drehachse D, verlaufen. Wird die Amplitude des Spulenstroms hingegen reduziert, so wandert der Permanentmagnet 14 aufgrund der von der Rückstelleinrichtung 12 aufgebrachten Rückstellkraft F wieder aus der Spule 19 heraus. Befindet sich die Spule im unbestromten Zustand, so wird der Permanentmagnet 14 durch die Rückstellkraft, welche in negativer z-Richtung wirkt, in einer Ruheposition gehalten. Insgesamt ist jedoch zu beachten, dass der Permanentmagnet 14 niemals vollständig in das Spulenpaket eintaucht bzw. vollständig aus dem Spulenpaket heraustritt, sondern über die gesamte Hubstrecke mit zumindest einem Spulenpaket nur teilweise überlappt. Falls der Permanentmagnet über seine gesamte Länge gleichzeitig mit allen Spulen vollständig überlappen würde, würden sich die Axialkräfte vollständig aufheben, so dass die Variation des Spulenstroms keinerlei Auswirkung mehr auf eine translatorische Lageveränderung in Richtung der Drehachse D hätte. Um dies zu gewährleisten weist der Antrieb 13 Vorteilhafterweise Anschläge 21 an den Führungsstäben 16 oder am Gehäuse auf, welche die Hubbewegung des Permanentmagneten 14 entsprechend begrenzen. Vorzugsweise beträgt der Anteil, mit dem der Permanentmagnet 14 in das Spulenpaket 19 eintaucht, 25 bis 75 Prozent der Gesamtlänge des Spulenpakets 19.

In den Darstellungen der Figur 8B wird gezeigt, wie sich der Permanentmagnet 14 bei Variation der Stromrichtung bzw. des Phasenwinkels ϕ des Spulenstroms verhält: Wird der Phasenwinkel ϕ vergrößert (linke Darstellung in Figur 8B), so hat dies eine rotatorische Bewegung des Permanentmagneten nach links zur Folge, abzulesen an der punktförmigen Markierung am oberen Rand des Permanentmagneten 14. Wird jedoch der Phasenwinkel ϕ verkleinert (rechte Darstellung in Figur 8B), so hat dies eine rotatorische Bewegung des Permanentmagneten 14 nach rechts zur Folge (vgl. Stellung der Markierung in der rechten Darstellung in Figur 8B). Verantwortlich für die Drehbewegung sind diejenigen Richtungsanteile des Spulenstroms, die parallel zur Drehachse D verlaufen.

### Bezugszeichenliste:

- 1: Bestückautomat
- 2: Substrat
- 3: Transportstrecke
- 4: Bestückkopf
- 5: Positionierarm
- 6: Träger
- 7: Steuereinrichtung
- 8: Zuführeinrichtung
- 9: Gehäuse
- 10: Halteeinrichtung
- 11: Bauteile
- 12: Rückstelleinrichtung
- 13: Dreh-Hub-Motor / Hubantrieb
- 14: Permanentmagnet
- 15: Rückschlusseinrichtung / magnetischer Rückschluss
- 16: Führungsstab
- 17: Führungskanal
- 18: Führungseinrichtung
- 19: Spulenpakete
- 20: Antriebssteuerung
- 21: Anschläge
- 27: Befestigungselement

## Patentansprüche

1. Bestückkopf (4) zum Bestücken von Substraten (2) mit elektrischen Bauteilen (11), mit
- einem Gehäuse (9),
- einer Halteeinrichtung (10) zum Halten der Bauteile (11), welche in einer Verschieberichtung zwischen einer Ruheposition und einer Arbeitsposition verschiebbar am Gehäuse (9) gelagert ist, wobei die Ruheposition und die Arbeitsposition in der Verschieberichtung um eine Hubstrecke (□z) beabstandet sind,
- einer Rückstelleinrichtung (12), mit
• einem Permanentmagneten (14), welcher quer zur Verschieberichtung magnetisiert ist,
• einer magnetischen Rückschlusseinrichtung (15), welche derart mit dem Permanentmagneten (14) zusammenwirkt, dass sich ein magnetischer Rückschluss bildet,
wobei der Permanentmagnet (14) relativ zur Rückschlusseinrichtung (15) in der Verschieberichtung um die Hubstrecke (Δz) verschiebbar ist, und die Rückschlusseinrichtung (15) in Verschieberichtung zumindest zwei Abschnitte (A, B) mit unterschiedlichem magnetischen Widerstand aufweist und derart ausgebildet ist, dass der Permanentmagnet (14) beim Verschieben über die Hubstrecke (Δz) gleichzeitig mit zumindest zwei Abschnitten (A, B) der Rückschlusseinrichtung (15) überlappt,
wobei die Rückstelleinrichtung (12) derart mit dem Gehäuse (9) und der Halteeinrichtung (10) gekoppelt ist, dass die Rückstelleinrichtung (12) auf die Halteeinrichtung (10) über die Hubstrecke (Δz) eine Rückstellkraft (F) ausübt, welche die Halteeinrichtung (10) in die Ruhelage drängt.

2. Bestückkopf (4) nach Anspruch 1, wobei die Rückschlusseinrichtung (15) mit dem Gehäuse (9) und der Permanentmagnet (14) mit der Halteeinrichtung (10) fest verbunden sind.

3. Bestückkopf (4) nach Anspruch 1, wobei der Permanentmagnet (14) mit dem Gehäuse (9) und die Rückschlusseinrichtung (15) mit der Halteeinrichtung (10) fest verbunden sind.

4. Bestückkopf (4) nach einem der Ansprüche 1 bis 3, wobei die Abschnitte (A, B) Materialien mit unterschiedlichem magnetischen Widerstand aufweisen.

5. Bestückkopf (4) nach einem der Ansprüche 1 bis 3, wobei die Abschnitte (A, B) von dem Permanentmagneten (14) unterschiedlich weit beabstandet sind.

6. Bestückkopf (4) nach einem der Ansprüche 1 bis 3, wobei die Abschnitte (A, B) derart ausgebildet sind, dass die Rückstellkraft (F) über die gesamte Hubstrecke (Δz) konstant ist.

7. Bestückkopf (4) nach einem der Ansprüche 1 bis 6, wobei sich ein von der Halteeinrichtung (10) gehaltenes Bauteil (11) in der Ruheposition näher am Gehäuse (9) befindet als in der Arbeitsposition.

8. Bestückkopf (4) nach einem der Ansprüche 1 bis 7, mit einem elektromagnetischen Antrieb (13) zum Bewegen der Halteeinrichtung (10) in der Verschieberichtung, wobei der Antrieb (13) ein am Gehäuse (9) befestigtes Stationärteil mit zumindest einem zylindrischen Spulenpaket (19) aufweist, und wobei der Permanentmagnet (14) Teil eines Mobilteils des Antriebs (13) darstellt, welches bei Betrieb mit dem Spulenpaket (19) zusammenwirkt.

9. Bestückkopf (4) nach Anspruch 8, wobei
- das Mobilteil als Rotor ausgebildet ist und relativ zum Stationärteil um eine zur Verschieberichtung parallele Drehachse (D) drehbar gelagert ist,
- das Spulenpaket (19) des Stationärteils mehrphasig ausgestaltet ist, und
- der Bestückkopf (4) eine Antriebssteuerung (20) aufweist, welche mit dem mindestens einen Spulenpaket (19) gekoppelt ist, und mittels der der Strom durch das Spulenpaket (19) derart steuerbar ist, dass das durch den Strom verursachte Magnetfeld des Stationärteils mit dem Magnetfeld des Mobilteils wechselwirkt und sowohl eine Verschiebung als auch eine Rotation des Rotors bewirkt.

10. Bestückkopf nach Anspruch 9, wobei das Stationärteil ein Spulenpaket (19) in Form eines zylinderförmigen Hohlkörpers aufweist, mit einer Wicklung, welche derart gestaltet ist, dass die Steigung über die einzelnen Windungsgänge entlang des Umfangs des zylinderförmigen Hohlkörpers verläuft.

11. Bestückautomat (1) zum Bestücken von Substraten (2) mit elektrischen Bauteilen (11), mit einem Bestückkopf (4) nach einem der Ansprüche 1 bis 10.

## Claims

1. Placement head (4) for populating substrates (2) with electrical components (11), having
- a housing (9),
- a holding device (10) for holding the components (11) which is mounted on a housing (9) so as to be displaced in a direction of displacement between a rest position and a working position, the rest position and the working position being interspaced by a travel path (Δz) in the direction of displacement,
- a readjusting mechanism (12), having
• a permanent magnet (14) which is magnetised at a right angle to the direction of displacement,
• a magnetic return path element (15) which interacts with the permanent magnet (14) in such a manner as to generate magnetic flux,
the permanent magnet (14) being displaceable by the travel path (Δz) in the direction of displacement relative to the return path element (15), and the return path element (15) comprising at least two sections (A, B) of different magnetic resistance in the direction of displacement and being configured in such a manner that the permanent magnet (14) overlaps at least two sections (A, B) at a time of the return path element (15) when it is displaced across the travel path (Δz),
the readjusting mechanism (12) being coupled to the housing (9) and the holding device (10) in such a manner that the readjusting mechanism (12) exerts a readjusting force (F) on the holding device (10) across the travel path (Δz), said readjusting force forcing the holding device (10) into the rest position.

2. Placement head (4) according to claim 1, the return path element (15) being permanently connected to the housing (9), and the permanent magnet (14) to the holding device (10).

3. Placement head (4) according to claim 1, the permanent magnet (14) being permanently connected to the housing (9), and the return path element (15) to the holding device (10).

4. Placement head (4) according to one of claims 1 to 3, the sections (A, B) having materials with different magnetic resistance.

5. Placement head (4) according to one of claims 1 to 3, the sections (A, B) being disposed at different distances from the permanent magnet (14).

6. Placement head (4) according to one of claims 1 to 3, the sections (A, B) being configured in such a manner that the readjusting force (F) is constant over the entire travel path (Δz).

7. Placement head (4) according to one of claims 1 to 6, a component (11) held by the holding device (10) being located in the rest position closer to the housing (9) than in the working position.

8. Placement head (4) according to one of claims 1 to 7, having an electromagnetic drive (13) for moving the holding device (10) in the direction of displacement, the drive (13) having a stationary part fixed to the housing (9) with at least one cylindrical coil packet (19), and the permanent magnet (14) representing part of a mobile part of the drive (13) which interacts with the coil packet (19) during operation.

9. Placement head (4) according to claim 8,
- the mobile part being configured as a rotor and being rotatably mounted relative to the stationary part about an axis of rotation (D) parallel to the direction of displacement,
- the coil packet (19) of the stationary part being embodied in multiphase fashion, and
- the placement head (4) having a drive controller (20) which is coupled to the at least one coil packet (19), and by means of which the current through the coil packet (19) can be controlled such that the magnetic field of the stationary part caused by the current interacts with the magnetic field of the mobile part and effects both a displacement and a rotation of the rotor.

10. Placement head (4) according to claim 9, the stationary part having a coil packet (19) in the form of a cylindrical hollow body, with a thread which is designed such that the pitch runs via the individual thread pitches along the circumference of the cylindrical hollow body.

11. Placement machine (1) for populating substrates (2) with electrical components (11), having a placement head (4) according to one of claims 1 to 10.

## Revendications

1. Tête d'équipement (4) destinée à l'équipement de substrats (2) avec des composants électriques (11), comprenant
- un boîtier (9),
- un dispositif de maintien (10) destiné à maintenir les composants (11), lequel est logé de manière coulissante sur le boîtier (9) dans un sens de déplacement entre une position de repos et une position de travail, la position de repos et la position de travail étant distancées d'un trajet de course (Δz) dans le sens de déplacement ;
- un dispositif de rappel (12) comportant
• un aimant permanent (14), lequel est magnétisé transversalement au sens de déplacement,
• un dispositif de reflux magnétique (15), lequel agit avec l'aimant permanent (14) de manière à ce qu'un reflux magnétique se forme,
l'aimant permanent (14) étant déplaçable du trajet de course (Δz) dans le sens de déplacement, de manière relative par rapport au dispositif de reflux (15), et le dispositif de reflux (15) présentant dans le sens de déplacement au moins deux sections (A, B) ayant une résistance magnétique différente et étant réalisé de manière à ce que l'aimant permanent (14), lors du déplacement sur le trajet de course (Δz), recouvre simultanément au moins deux sections (A, B) du dispositif de reflux (15),
le dispositif de rappel (12) étant couplé au boîtier (9) et au dispositif de maintien (10) de manière à ce que le dispositif de rappel (12) exerce une force de rappel (F) sur le dispositif de maintien (10) sur le trajet de course (Δz), laquelle pousse le dispositif de maintien (10) en position de repos.

2. Tête d'équipement (4) selon la revendication 1, le dispositif de reflux (15) étant raccordé au boîtier (9) de manière fixe et l'aimant permanent (14) étant raccordé de manière fixe au dispositif de maintien (10).

3. Tête d'équipement (4) selon la revendication 1, l'aimant permanent (14) étant raccordé de manière fixe au boîtier (9) et le dispositif de reflux (15) étant raccordé de manière fixe au dispositif de maintien (10).

4. Tête d'équipement (4) selon l'une quelconque des revendications 1 à 3, les sections (A, B) présentant des matières ayant une résistance magnétique différente.

5. Tête d'équipement (4) selon l'une quelconque des revendications 1 à 3, les sections (A, B) étant différemment distancées de l'aimant permanent (14).

6. Tête d'équipement (4) selon l'une quelconque des revendications 1 à 3, les sections (A, B) étant réalisées de manière à ce que la force de rappel (F) soit constante sur tout le trajet de course (Δz).

7. Tête d'équipement (4) selon l'une quelconque des revendications 1 à 6, un composant (11) maintenu par le dispositif de maintien (10) se trouvant, en position de repos, plus près du boîtier (9) qu'en position de travail.

8. Tête d'équipement (4) selon l'une quelconque des revendications 1 à 7, comprenant un entraînement électromagnétique (13) destiné à déplacer le dispositif de maintien (10) dans le sens de déplacement, l'entraînement (13) présentant une pièce stationnaire fixée sur le boîtier (9) et munie d'au moins un paquet de bobines cylindrique (19), et l'aimant permanent (14) représentant une partie d'une pièce mobile de l'entraînement (13), laquelle agit avec le paquet de bobines (19) en fonctionnement.

9. Tête d'équipement (4) selon la revendication 8,
- la pièce mobile étant réalisée en tant que rotor et étant logée de manière rotative, par rapport à la pièce stationnaire, autour d'un axe de rotation (D) parallèle au sens de déplacement,
- le paquet de bobines (19) de la pièce stationnaire étant réalisé de manière polyphasée et
- la tête d'équipement (4) présentant une commande d'entraînement (20), laquelle est couplée à l'au moins un paquet de bobines (19) et au moyen de laquelle le courant peut être commandé au moyen du paquet de bobines (19) de manière à ce que le champ magnétique, causé par le courant, de la pièce stationnaire interagit avec le champ magnétique de la pièce mobile et cause aussi bien un déplacement qu'une rotation du rotor.

10. Tête d'équipement (4) selon la revendication 9, la pièce stationnaire présentant un paquet de bobines (19) sous forme d'un corps creux de forme cylindrique, comprenant un enroulement lequel est réalisé de manière à ce que la pente sur les différents pas de spire passe le long de la circonférence du corps creux en forme de cylindre.

11. Automate d'équipement (1) destiné à équiper des substrats (2) avec des composants électriques (11), comprenant une tête d'équipement (4) selon l'une quelconque des revendications 1 à 10.
